# DEMANDE DE BREVET EUROPEEN

(11) **EP 0 964 434 A2**
(43) Date de publication de la demande: **15.12.1999**
(21) Numéro de dépôt: 99410071.7
(22) Date de dépôt: 25.05.1999
(51) Int. Cl.: H01L 21/00

(54) **Dispositif adaptateur pour des boîtes de confinement d'au moins un objet plat sous atmosphère ultrapropre**

(30) Priorité: 08.06.1998 FR 9807317
(71) Demandeur: Incam Solutions, 38054 Grenoble cédex 9 (FR)
(72) Inventeur: Doche, Claude, 38640 Claix (FR)
(74) Mandataire: Hecké, Gérard

(57) **Abrégé**

Le dispositif adaptateur 20 est placé sur un plateau 22 mobile de l'embase du dispositif d'interface 2 pour positionner la boîte 10 à une hauteur prédéterminée permettant l'usage du système standard d'interfaçage avec les machines de l'équipement. Une paroi latérale 204 dudit dispositif adaptateur comporte une lumière 208 de guidage autorisant le passage de la boîte 10 pour amener la première porte 101 et son verrou 111 en alignement avec le plan d'appui frontal de la paroi latérale 204. Des moyens de commande sont prévus pour accoupler la première porte 101 avec la deuxième porte 21, et pour déverrouiller la première porte 101 lors de l'accostage de la paroi latérale 204 contre la face avant du dispositif d'interface 2.

## Description

### Domaine technique de l'invention

L'invention est relative à un dispositif adaptateur pour des boîtes de confinement d'au moins un objet plat sous atmosphère ultrapropre, chaque boîte comprenant un corps allongé obturable au moyen d'une première porte associée à un premier verrou, et susceptible d'être placée en regard d'une deuxième porte d'un dispositif d'interface pour réaliser le transfert de l'objet plat des boîtes vers l'équipement de production.

### Etat de la technique antérieure

Il existe des boîtes ou containers collectifs renfermant une série de plaques de silicium, ayant par exemple chacune un diamètre de 300 mm. Ces containers sont ouverts au niveau des équipements de production par l'intermédiaire du dispositif d'interface permettant l'accès aux plaquettes. Un tel dispositif d'interface est décrit en détail dans le document EP-A-0 735 573.

La technologie de manipulation collective des plaques de silicium a engendré des standards d'interfaçage des machines, utilisés couramment pour la production. Ce système de transport des plaques de silicium, et de transfert avec des machines de production s'avère néanmoins inadapté pour la gestion des plaques de test. Ces dernières sont utilisées seules, ou en nombre réduit, et servent pour le réglage des machines.

L'incorporation d'une seule plaque de silicium dans une boîte collective pouvant en contenir jusqu'à vingt cinq, aurait des incidences significatives sur l'économie du système de production, étant donné que la manipulation individuelle des plaques de test représente une fraction importante de l'ordre de 15% à 20% de l'encours d'une unité de production.

Pour résoudre cet inconvénient, il suffirait d'utiliser des containers individuels, par exemple décrits dans le document FR-A-96 04173, ou contenant quelques plaques, pour manipuler et stocker les plaques de test. L'usage de containers différents pose néanmoins le problème de la compatibilité avec le dispositif d'interfaçage standardisé.

### Objet de l'invention

L'objet de l'invention consiste à réaliser un dispositif d'adaptation permettant d'utiliser les moyens d'interfaçage des équipements pour le cycle d'ouverture et de fermeture des boîtes de confinement collectives pour l'ouverture et la fermeture des boîtes individuelles.

Selon l'invention, le dispositif adaptateur est placé sur un plateau mobile de l'embase du dispositif d'interface pour positionner la boîte à une hauteur prédéterminée permettant l'usage du système standard d'interfaçage avec les machines de l'équipement. Une paroi latérale dudit dispositif adaptateur comporte une lumière de guidage autorisant le passage de la boîte pour amener la première porte et son verrou en alignement avec le plan d'appui frontal de la paroi latérale. Des moyens de commande sont prévus pour accoupler la première porte avec la deuxième porte, et pour déverrouiller la première porte lors de l'accostage de la paroi latérale contre la face avant du dispositif d'interface.

Selon un premier mode d'utilisation, le dispositif adaptateur est d'abord installé sur le plateau du dispositif d'interface, et reçoit ensuite la boîte de confinement.

Selon un deuxième mode d'utilisation, la boîte de confinement est d'abord installée sur le dispositif adaptateur, l'ensemble étant ensuite positionné sur le plateau en se comportant comme une boîte collective par rapport au dispositif d'interface.

Selon une caractéristique de l'invention, la boîte est montée sur un plateau support du dispositif adaptateur, lequel comporte des moyens de positionnement pour le centrage de la boîte, des moyens de retenue pour son maintien stable sur le plateau support, et des moyens de lecture et de transmission des informations relatives aux boîtes individuelles ou collectives.

Le dispositif adaptateur est placé avantageusement sur un dispositif de rangement, lequel peut être fixé à demeure au dispositif d'interface, soit être mobile pour s'adapter à plusieurs dispositifs d'interfaces.

Selon une autre caractéristique de l'invention, le dispositif de rangement est équipé d'un tiroir coulissant déplaçable à partir d'une position de stockage vers une position de saillie pour autoriser le chargement automatique du dispositif adaptateur sur le plateau du dispositif d'interface. Le tiroir coulissant est doté d'un mécanisme élévateur pour soulever le dispositif adaptateur à partir de la position de saillie jusqu'à une position relevée correspondant sensiblement au niveau du plateau mobile du dispositif d'interface.

Selon une autre caractéristique de l'invention, la paroi latérale du dispositif adaptateur est rendue mobile pour autoriser un chargement par le haut de la boîte, et coopère d'autre part avec un dispositif de guidage associé à un ressort de rappel pour assurer le verrouillage et le déverrouillage des moyens de retenue.

Pour supprimer les problèmes de contamination induite par la paroi latérale du dispositif d'interface lors du retrait des deux portes, la face externe de la paroi latérale est recouverte par une plaquette de protection, laquelle est automatiquement enlevée de ladite face, et transférée sur la deuxième porte au moment de la liaison mécanique des deux portes, suite au recul du dispositif de guidage dans le sens du verrouillage, après accostage de la paroi latérale avec la face avant du dispositif d'interface. La contamination se trouve ainsi piégée entre la plaquette et la deuxième porte.

Selon une variante, la face externe de la paroi latérale porte un bloc adhésif multifeuilles interchangeable, le retrait d'une feuille contaminée intervenant à chaque utilisation du dispositif adaptateur pour laisser apparaître une nouvelle feuille exempte de contamination particulaire.

### Description des dessins

D'autres avantages et caractéristiques ressortiront plus clairement de la description qui va suivre de différents modes de réalisation, donnés à titre d'exemples non limitatifs, et représentés aux dessins annexés, dans lesquels :
- la figure 1 est une vue schématique en coupe d'un dispositif de l'art antérireur pour le transfert des plaques d'une boîte collective vers l'équipement de production;
- la figure 2 représente l'utilisation du dispositif adaptateur selon l'invention avec une boîte individuelle;
- les figures 3A, 3B et 3C représentent successivement les phases de chargement, d'accostage, et d'ouverture lors du fonctionnement comparé du système à boîte collective selon l'art antérieur ( à gauche), et du système à boîte individuelle selon l'invention ( à droite);
- la figure 4 montre une vue en perspective du dispositif adaptateur;
- la figure 5 montre le positionnement de la première porte en alignement avec le plan d'appui frontal de la paroi latérale extérieure du dispositif adaptateur;
- les figures 6A et 6B montrent des vues similaires d'une variante de réalisation du dispositif adaptateur de la figure 2, respectivement en position de chargement, et en position de verrouillage de la boîte après accostage;
- la figure 7 est une vue identique de la figure 6B après le retrait des deux portes;
- les figures 8A et 8B sont des vues identiques des figures 6A et 6B d'une autre variante de réalisation du dispositif adaptateur;
- les figures 9A et 9B représentent respectivement des vues en coupe et en élévation du dispositif adaptateur stocké sur un dispositif de rangement;
- les figures 10A à 10C montrent les différentes phases de manipulation du dispositif adaptateur à partir de son dispositif de rangement jusqu'au dépôt sur le plateau du dispositif d'interface;
- la figure 11 représente une desserte mobile associée au dispositif adaptateur selon l'invention pour reconfigurer un système d'ouverture standard;
- les figures 12a, 12b, et 12c montrent les différentes phases de dépose du dispositif adaptateur selon l'invention à partir d'une desserte mobile;
- la figure 13 montre l'application du dispositif adaptateur selon l'invention pour une boîte à cinq plaques.

### Description détaillée de modes de réalisation

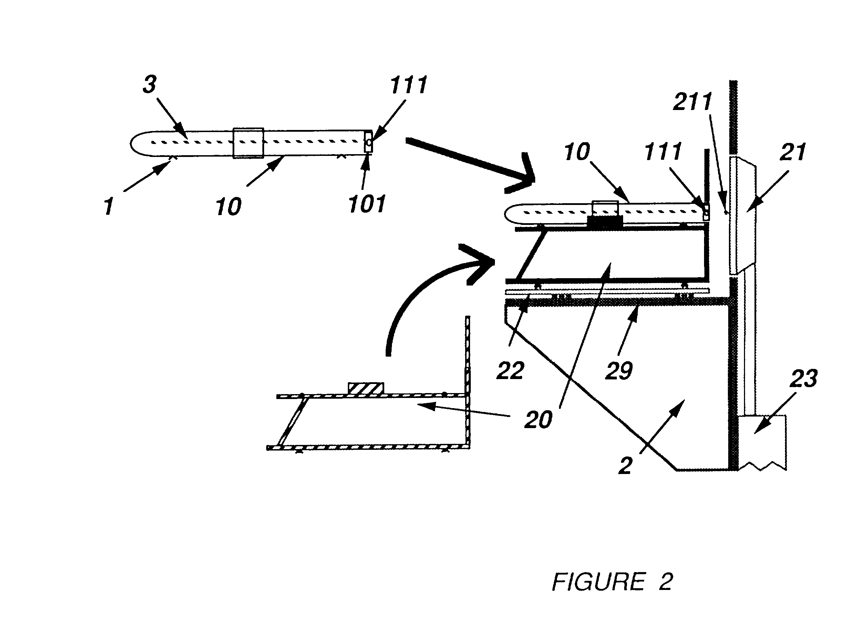

En référence à la figure 2, le dispositif adaptateur désigné par le repère général 20, est utilisé pour positionner en hauteur une boîte individuelle 10 sur un dispositif d'interface 2 d'un équipement de production ( non représenté). La boîte individuelle 10 comprend un corps 1 en matière plastique ou métallique, et de forme allongée, renfermant un objet plat 3, par exemple une plaque de silicium de 300 mm de diamètre. La face latérale de la boîte individuelle 10 est dotée d'un orifice obturable au moyen d'une première porte 101 équipée d'un premier verrou 111 agencé pour assurer l'ouverture et la fermeture de la porte 101. La structure d'une telle boîte est décrite dans les demandes de brevets français N° 9212423 et 9604173.

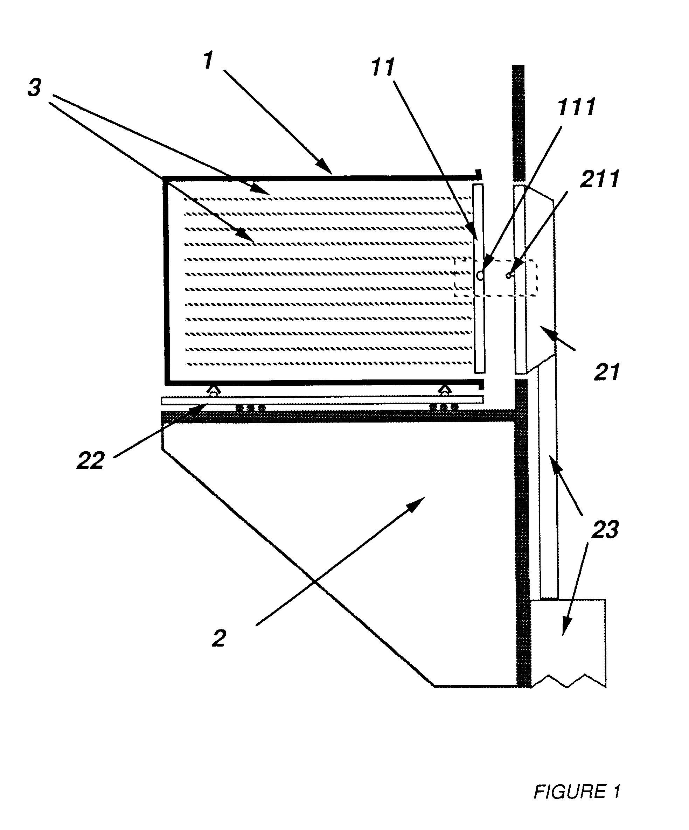

Le dispositif d'interface 2, du type décrit dans le document EP 0735 573, comporte un mécanisme de manoeuvre 23 accouplé à une deuxième porte 21, laquelle est pourvue d'un deuxième verrou 211 susceptible de coopérer avec le premier verrou 111 lors du transfert de l'objet plat 3. Un plateau 22 mobile est placé sur l'embase 29 horizontale du dispositif d'interface 2, et sert de support au dispositif adaptateur 20. Deux modes d'utilisation sont possibles :
- la boîte individuelle 10 est disposée sur le dispositif adaptateur 20 après l'installation de ce dernier sur le plateau 22 ( cas de la figure 2);
- la boîte individuelle 10 est d'abord installée sur le dispositif adaptateur 20, et l'ensemble vient ensuite se positionner sur le plateau 22, comme dans le cas d'une boîte collective 1 de la figure 1.

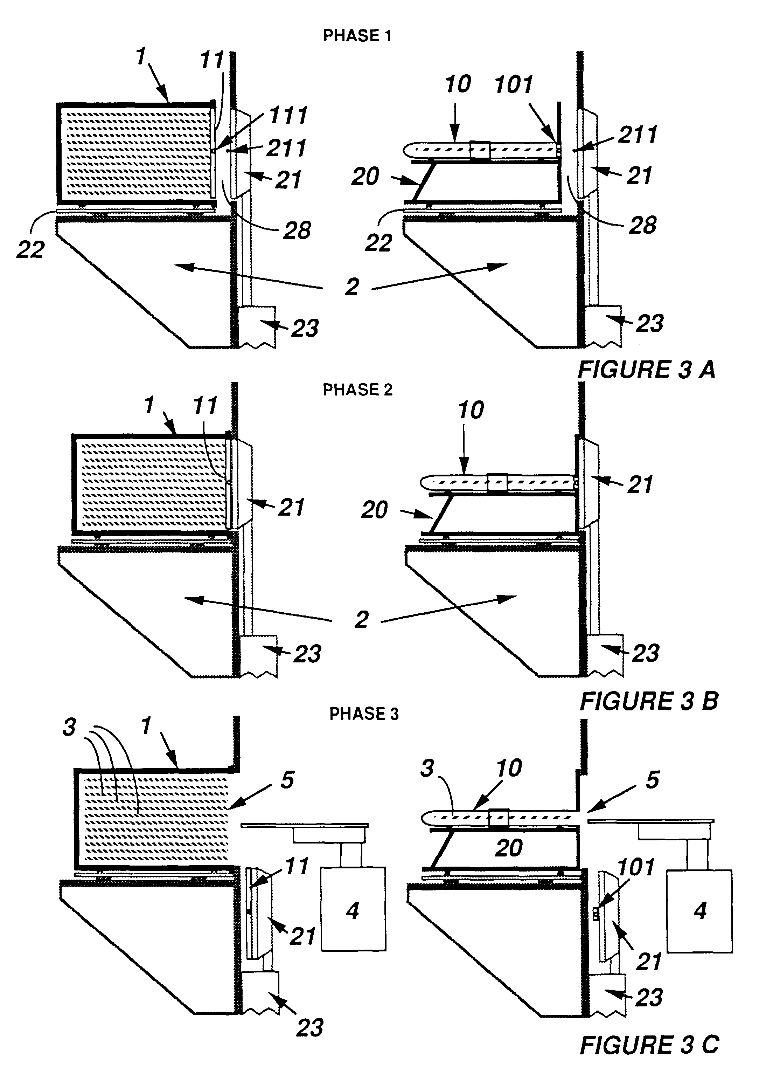

Les figures 3A-3C montrent le procédé de transfert comparatif entre des boîtes collectives 1 ( à gauche), et des boîtes individuelles 10 ( à droite ). Grâce à la présence du dispositif adaptateur 20, le même dispositif d'interface 2 de l'équipement pour des boîtes collectives 1 est utilisable pour ouvrir ou fermer des boîtes individuelles 10. Le mécanisme de manoeuvre 23 permet ainsi d'enlever la première porte 101 de la boîte individuelle 10 en lieu et place de la porte 11 de la boîte collective 1.

Le déroulement séquentiel du processus d'ouverture des deux configurations est le suivant :

Sur la figure 3A correspondant à la phase de chargement, la boîte collective 1 et la boîte individuelle 10 sont installées et verrouillées sur le plateau 22 mobile du dispositif d'interface 2. Un intervalle 28 de faible épaisseur sépare les deux verrous 111, 211 et les deux portes 11, 101; 21 respectives.

Sur la figure 3B correspondant à la phase d'accostage, le plateau 22 mobile est déplacé en translation pour amener la boîte collective 1 et la boîte individuelle 10 en contact avec la deuxième porte 21 du dispositif d'interface 2. Les deux verrous 111, 211 coopèrent entre eux pour accoupler mécaniquement la première porte 11 ou 101 avec la deuxième porte 21, et pour déverrouiller la première porte 11, 101 de la boîte 1, 10 respective. La deuxième porte 21 reste immobile durant cette phase d'accostage.

Sur la figure 3C correspondant à la phase d'ouverture des boîtes 1, 10, le mécanisme de manoeuvre 23 est animé d'un mouvement combiné de translation horizontale et verticale pour entraîner simultanément les deux portes 11, 101; 21 vers une position de retrait située dans la partie interne inférieure du dispositif d'interface 2. L'orifice d'entrée 5 de la boîte 1, 10 est alors libérée, permettant l'intervention d'un robot 4 pour échanger la (les) plaque(s) 3 avec l'équipement .

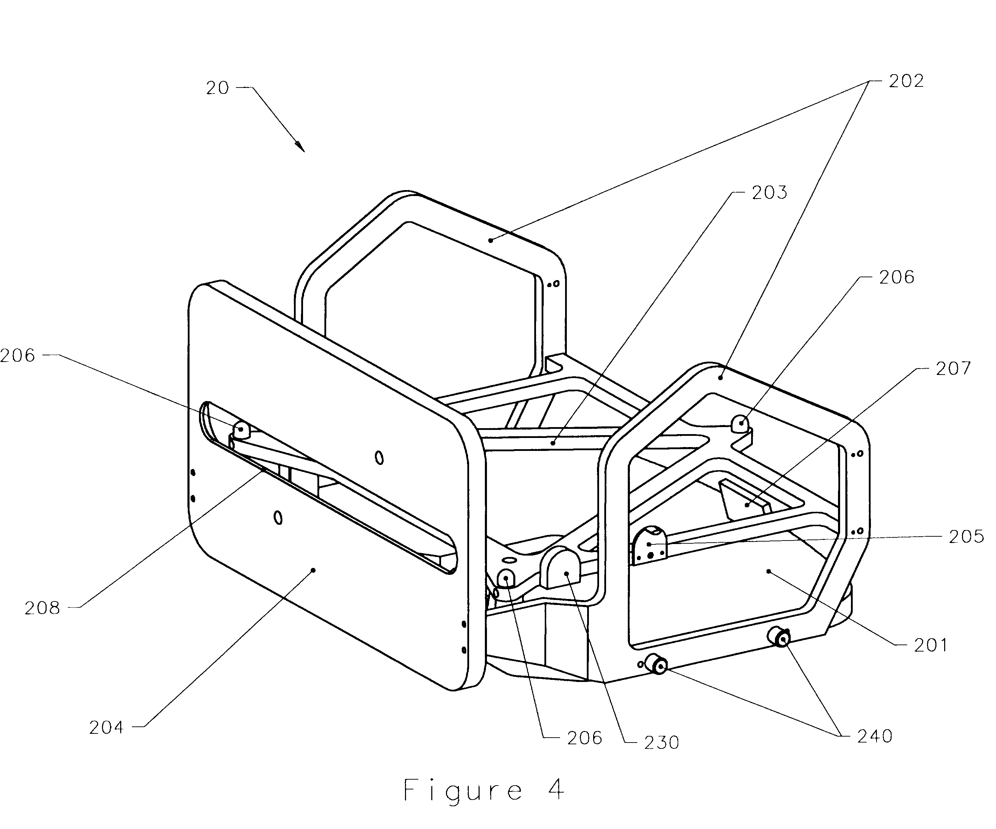

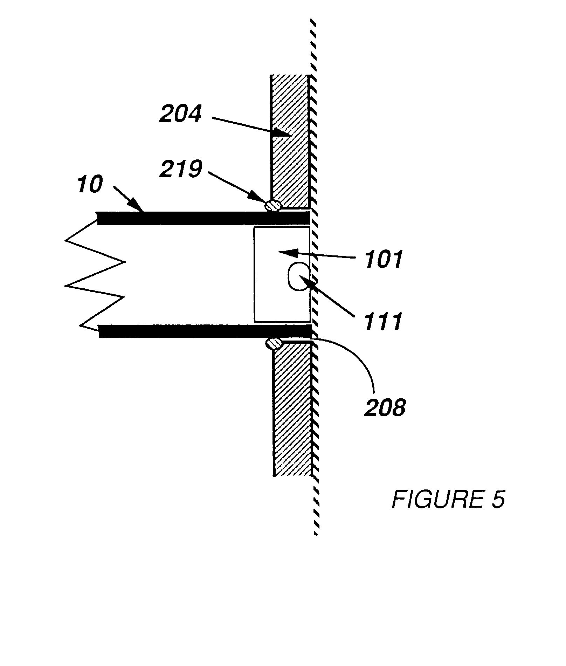

En référence à la figure 4 représentant la version de base du dispositif adaptateur 20, la partie inférieure du socle 201 est équipée de moyens de repères mécaniques destinés à assurer le fonctionnement standard du dispositif adaptateur 20 sur le plateau 22 mobile du dispositif interface 2. Au socle 201 est assujettie une paroi latérale 204 comportant une lumière 208 permettant le passage de la boîte individuelle 10, de manière à positionner la première porte 101 et son verrou 111 en alignement avec le plan d'appui frontal de la paroi latérale 204 extérieure du dispositif adaptateur 20, tel que montré à la figure 5. Un tel agencement est parfaitement adapté pour la liaison mécanique de la première porte 101 de la boîte individuelle 10 avec la deuxième porte 21 du dispositif interface 2 grâce à l'intervention des verrous 111, 211 respectifs. Un joint 219 installé en périphérie de la lumière 218, permet d'assurer l'étanchéité de la boîte et de l'équipement par rapport à l'extérieur du système.

Le décalage vertical de la lumière 208 par rapport à l'arête inférieure de la paroi latérale 204 correspond à la mise à hauteur de la boîte individuelle 10. Le dispositif adaptateur 20 comporte à cet effet un plateau support 203 parfaitement positionné en hauteur par rapport au socle 201, et destiné à recevoir la boîte individuelle 10. Le plateau support 203 horizontal s'étend perpendiculairement à la paroi latérale 204, et comporte des moyens de positionnement 206 pour le centrage de la boîte 10, ainsi que des moyens de retenue 205 pour le maintien stable de la boîte 10 sur le dispositif adaptateur 20. L'agencement des moyens de positionnement 206 et de retenue 205 sur le plateau support 203 est compatible avec les boîtes individuelles disponibles.

Le socle 201 est doté de deux bras de liaison 202 sur lesquels sont rapportés la paroi latérale 204 et le plateau support 203 pour former un ensemble rigide. Les deux bras de liaison 202 servent également de poignées de manutention du dispositif adaptateur 20.

Un lecteur 230 d'étiquettes électroniques est fixé sur le plateau support 203, et coopère avec un dispositif électronique de suivi de lot capable de transmettre l'information par voie infrarouge ou radiofréquence à un système de pilotage de la fabrication. La base de chaque bras de liaison 202 est pourvue de plots 240 saillants nécessaires à la manipulation du dispositif adaptateur 20.

Dans la version de base de la figure 4, la boîte individuelle 10 est chargée manuellement sur le plateau support 203, et son verrouillage par les moyens de retenue 205 intervient également par une action manuelle.

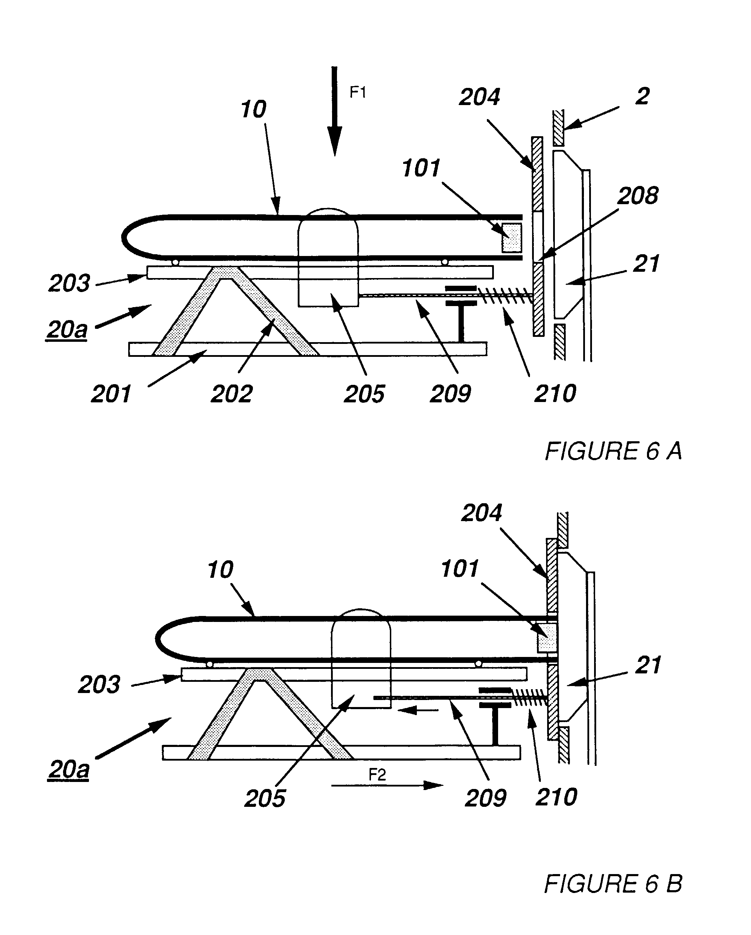

Sur les figures 6A et 6B, une variante de réalisation du dispositif adaptateur 20a est conçue pour autoriser un chargement vertical de la boîte individuelle 10 suite à l'intervention dans le sens de la flèche F1 du dispositif robotisé de transport ( non représenté). La paroi latérale 204 n'est plus solidarisée de manière fixe au socle 201, mais est rendue mobile pour permettre le chargement automatique par le haut.

Lors de la phase de chargement de la boîte individuelle 10 ( figure 6A), la paroi latérale 204 est sollicitée en translation vers une position inactive de retrait par l'action d'un dispositif de guidage 209 associé à un ressort de rappel 210. La paroi latérale 204 est écartée de la porte 101 pour libérer complètement l'espace de chargement. Les moyens de retenue 205 sont formés dans ce cas par un mécanisme automatique de verrouillage / déverrouillage de la boîte individuelle 10 sur le plateau support 203. Le dispositif de guidage 209 comporte un axe d'actionnement coopérant avec un mécanisme d'actionnement des moyens de retenue 205 pour dériver du mouvement de translation de l'axe, un mouvement de pivotement du système d'attache de la boîte 10.

Sur la figure 6B, le déplacement en translation du dispositif adaptateur 20a dans le sens de la flèche F2 autorise au moment de l'accostage de la paroi latérale 204 avec la face avant du dispositif d'interface 2, un mouvement poursuivi de la boîte 10 jusqu'à la position active de liaison des portes 101, 21 décrite en référence à la figure 5. Le recul dans le sens de la flèche F3 de l'axe d'actionnement du dispositif de guidage 209 provoque durant cette course, la compression du ressort 210, et le verrouillage de la boîte 10 sur le dispositif adaptateur 20a.

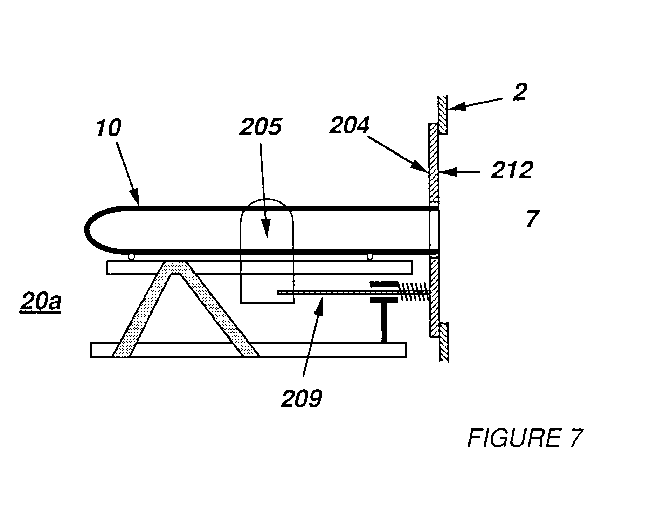

La figure 7 montre le dispositif de la figure 6B après le retrait des deux portes 101, 21. La face externe 212 de la paroi latérale 204 qui se trouve en permanence en relation avec un environnement moins contrôlé sur le plan particulaire, risque d'être contaminé par des particules. Cette face contaminée est disposée en regard de l'espace 7 ultra-propre de l'équipement, ce qui pose des problèmes de contamination induite dans le dispositif d'interface 2 par la face externe de la paroi 204.

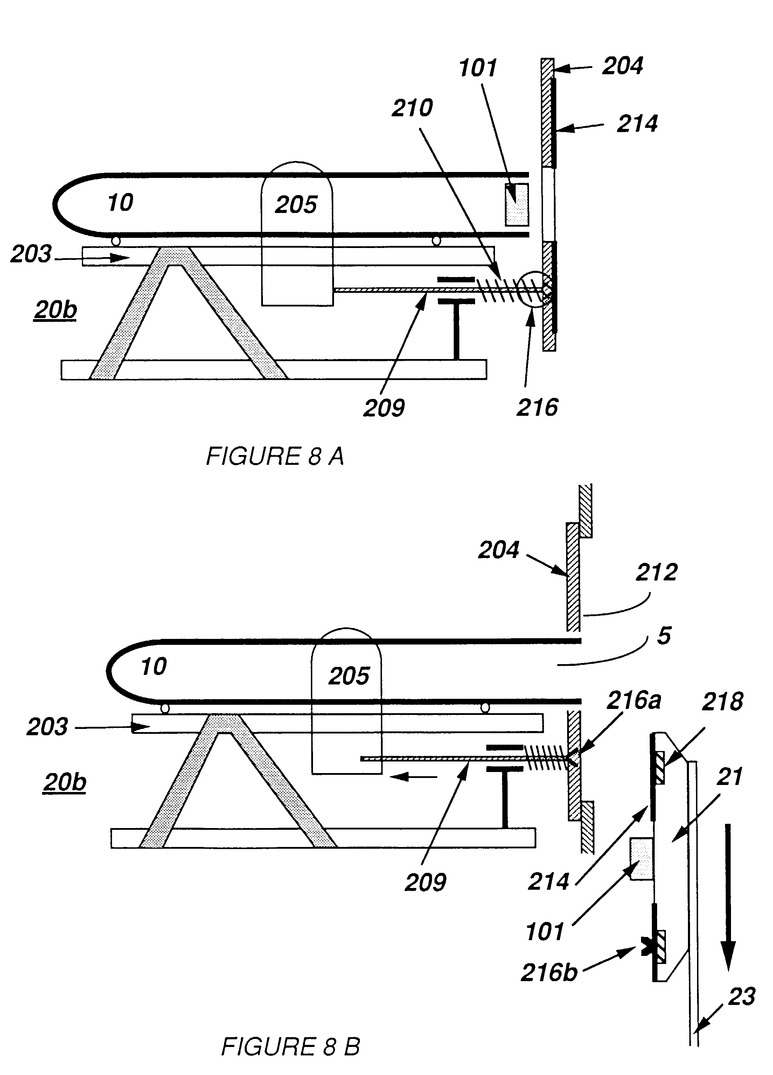

Les figures 8A et 8B montrent une autre variante du dispositif adaptateur 20b qui permet de résoudre ce problème de contamination. La face externe 212 de la paroi latérale 204 est recouverte par une plaquette 214 de protection, laquelle est automatiquement enlevée de la face 212, et transférée sur la deuxième porte 21 au moment de la liaison mécanique des deux portes 101, 21. La plaquette 214 est normalement fixée sur la paroi au moyen d'un organe de fixation 216 ayant une première partie 216a solidaire de l'axe d'actionnement du dispositif de guidage 209, et une deuxième partie 216b complémentaire assujettie à la plaquette 214. La deuxième partie 216b est libérée de la première partie 216a dès que se produit le recul du dispositif de guidage 209 au moment de l'accostage de la paroi latérale 204 avec la face avant du dispositif d'interface 2. La deuxième porte 21 est avantageusement équipée d'un dispositif de maintien 218 de la plaquette 214, notamment par aspiration.

Selon une variante de réalisation ( non représentée ), la plaquette 214 de protection peut être remplacée par un bloc adhésif à feuilles multiples, de même forme que la plaquette 214.. A chaque utilisation du dispositif adaptateur 20a, l'opérateur procède au retrait de la couche contaminée, pour libérer une nouvelle couche exempte de contamination particulaire. Le dispositif de maintien 218 n'est pas nécessaire dans ce cas. Différents matériaux peuvent être utilisés pour réaliser le bloc adhésif multifeuille :
- soit du papier spécial pour salle blanche revêtu d'une couche d'adhésif conventionnel,
- soit une multitude de feuilles très fines de polycarbonate maintenues entre elles par effet électrostatique.

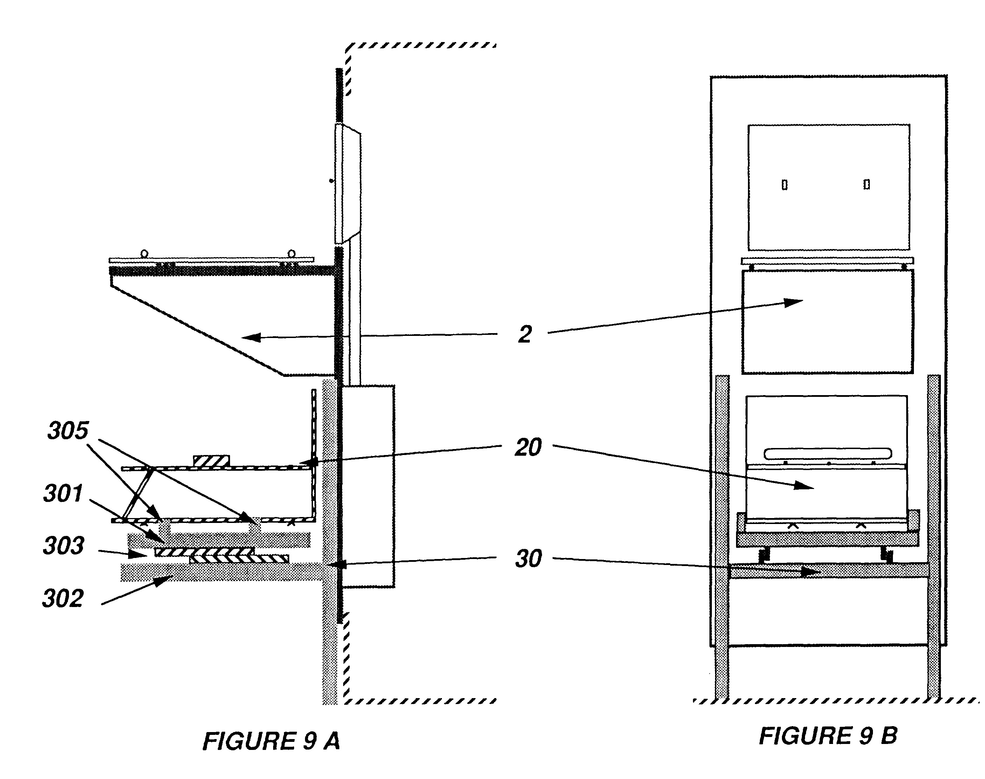

Les figures 9A et 9B montrent le dispositif adaptateur 20 utilisé en tant qu'accessoire du dispositif d'interface 2. Le dispositif adaptateur 20 est placé avantageusement sur la face supérieure d'un dispositif de rangement 30 fixé à la partie inférieure du dispositif d'interface 2, et comprenant une tablette 302 horizontale équipée d'un tiroir coulissant 301 prenant appui sur la tablette 302 au moyen d'organes de glissement ou de roulement 303. Le tiroir coulissant 301 se trouve dans la position de stockage en étant logé sous la partie saillante du dispositif d'interface 2. Un système de repères 305 permet de positionner le dispositif adaptateur 20 par rapport au tiroir coulissant 301.

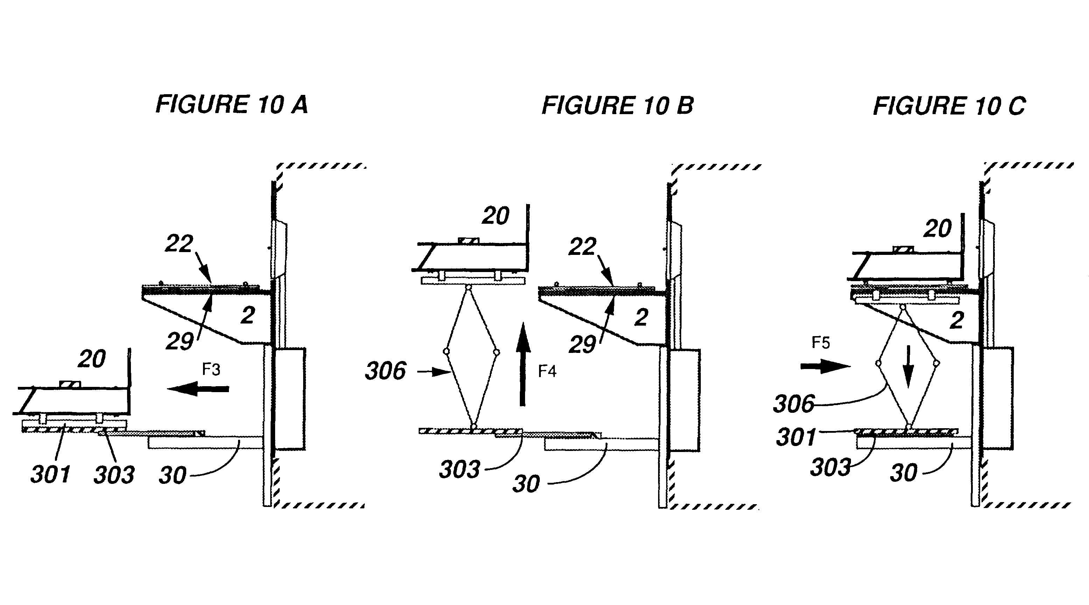

Les figures 10A-10C représentent les phases de retrait du tiroir coulissant 301 pour le transfert du dispositif adaptateur 20 vers le plateau 22 mobile de l'embase horizontale 29 du dispositif d'interface 2. A la figure 10A, le dispositif adaptateur 20 est déplacé en translation selon la flèche F3 jusqu'à une position de saillie pour échapper au socle de l'embase 29. Le tiroir 301 est doté d'un mécanisme élévateur 306 actionné par l'opérateur pour soulever le dispositif adaptateur 20 dans le sens de la flèche F4 jusqu'à une position relevée ( figure 10B). Le recul du tiroir coulissant 303 dans le sens de la flèche F5 vers la position effacée, permet ensuite de déposer le dispositif adaptateur 20 sur le plateau 22 mobile du dispositif d'interface 2 ( figure 10C). Le mécanisme élévateur 306 est formé à titre d'exemple par un système à panthographe, lequel reste déployé lors du dernier déplacement en translation dans le sens de la flèche F5. Un dispositif à contrepoids ( non représenté ) peut être associé au mécanisme élévateur 306 pour assister l'opérateur lors de la manoeuvre.

Dans la position de la figure 10C, le mécanisme élévateur 306 peut être actionné vers la position abaissée de manière à libérer le dispositif adaptateur 20. Ce dernier se déplacera seul lors de la phase d'accostage pendant le cycle de transfert.

Le mécanisme élévateur 306 peut également rester en liaison permanente avec le dispositif adaptateur 20. Le tiroir coulissant 303 suit dans ce cas le déplacement du dispositif adaptateur 20 jusqu'à la position d'accostage lors du cycle de transfert.

Il est clair que le mécanisme de chargement et de déchargement du dispositif adaptateur 20 peut être entièrement automatisé.

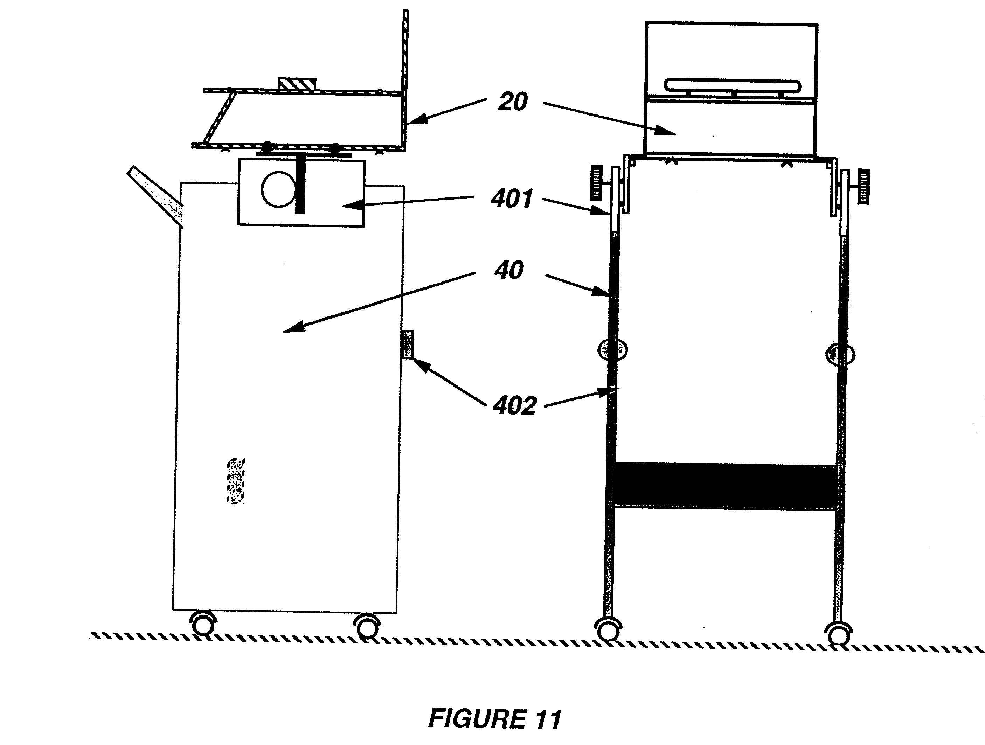

Sur la figure 11, le dispositif de rangement peut avantageusement prendre la forme d'une desserte 40 mobile permettant de déposer le dispositif adaptateur 20 sur tout type de dispositif d'interface.

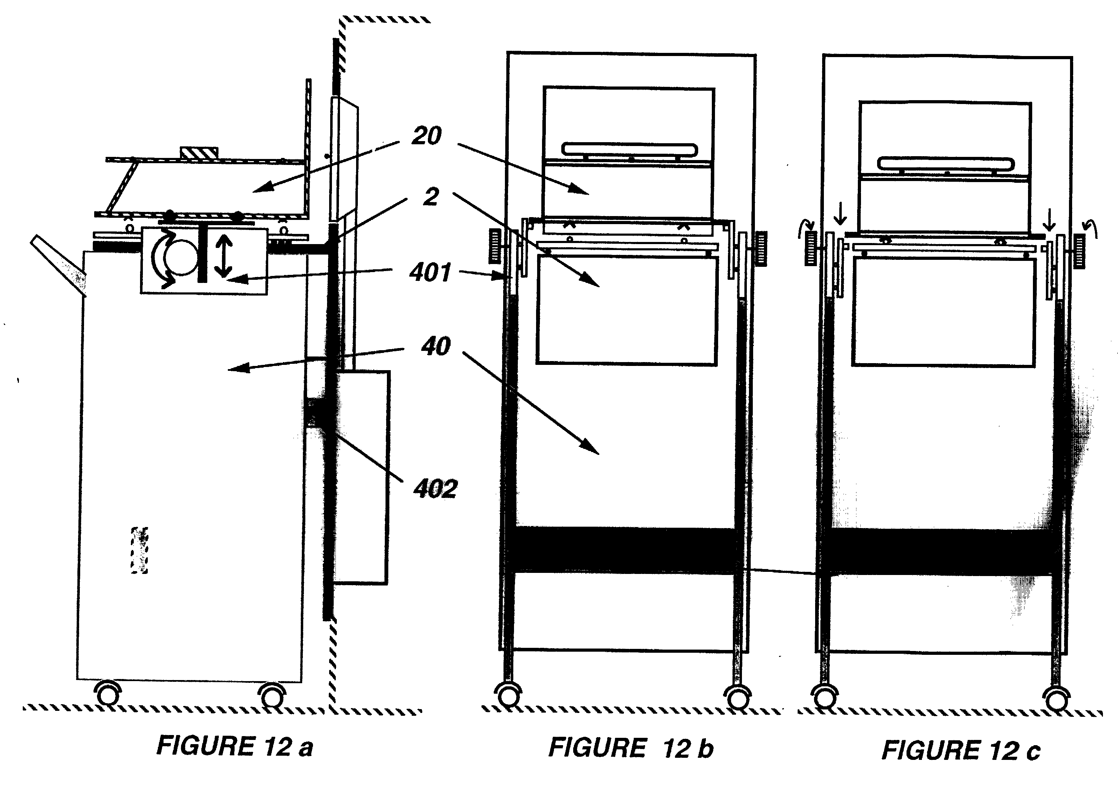

Sur les figures 12a - 12c, un mécanisme élévateur et abaisseur 401 permet d'une part le maintien de l'adaptateur 20 dans une position relevée pour échapper aux éléments de positionnement du système d'interface en position de chargement ( figures 12a et 12b), et d'autre part assure la dépose et la libération de l'adaptateur 20 sur les repères du plateau du système d'interface. Le desserte 40 mobile vient se placer par rapport au système d'interface grâce à des moyens de positionnement (402) de manière à autoriser une reconfiguration du système d'interface lui permettant de recevoir des containers individuels.

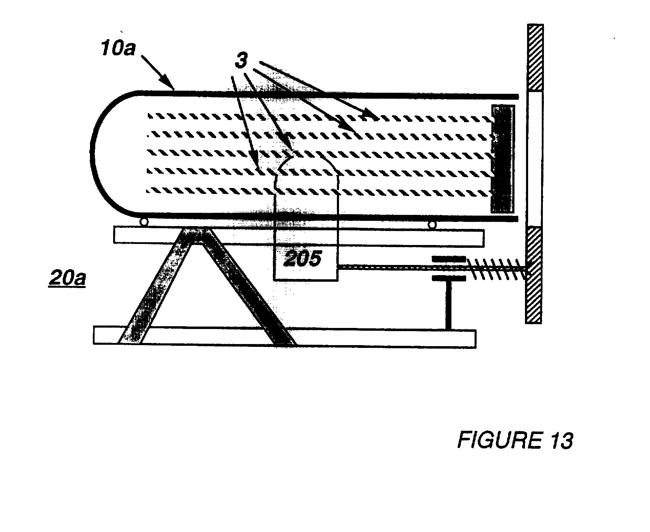

L'invention s'applique également à l'adaptation d'un boîtier 10a renfermant plusieurs plaques 3 de silicium , par exemple de l'ordre de cinq ( voir figure 13).

## Revendications

1. Dispositif adaptateur pour des boîtes de confinement d'au moins un objet plat (3) sous atmosphère ultrapropre, chaque boîte (10, 10a) comprenant un corps allongé obturable au moyen d'une première porte (101) associée à un premier verrou (111), et susceptible d'être placée en regard d'une deuxième porte (21) d'un dispositif d'interface (2) pour réaliser le transfert de l'objet plat (3) des boîtes (10, 10a) vers l'équipement de production,
caractérisé en ce que :
- le dispositif adaptateur (20, 20a, 20b) est placé sur un plateau (22) mobile de l'embase (29) du dispositif d'interface (2) pour positionner la boîte (10, 10a) à une hauteur prédéterminée permettant l'usage du système standard d'interfaçage avec les machines de l'équipement,
- une paroi latérale (204) dudit dispositif adaptateur comporte une lumière (208) de guidage autorisant le passage de la boîte (10, 10a) pour amener la première porte (101) et son verrou (111) en alignement avec le plan d'appui frontal de la paroi latérale (204), l'ensemble étant agencé pour accoupler la première porte (101) avec la deuxième porte (21), et pour déverrouiller la première porte (101) lors de l'accostage de la paroi latérale (204) contre la face avant du dispositif d'interface (2), les portes (101, 21) étant entraînées vers une position de retrait provoquant l'ouverture de l'orifice d'entrée (5) de la boîte (10, 10a) pour l'échange de l'objet (3) avec l'équipement.

2. Dispositif adaptateur selon la revendication 1, caractérisé en ce que le dispositif adaptateur (20, 20a, 20b) est d'abord installé sur le plateau (22) du dispositif d'interface (2), et reçoit ensuite la boîte de confinement (10, 10a).

3. Dispositif adaptateur selon la revendication 1, caractérisé en ce que la boîte de confinement (10, 10a) est d'abord installée sur le dispositif adaptateur (20, 20a, 20b), l'ensemble étant ensuite positionné sur le plateau (22) en se comportant comme une boîte collective par rapport au dispositif d'interface (2).

4. Dispositif adaptateur selon l'une des revendications 1 à 3, caractérisé en ce que la boîte (10, 10a) est montée sur un plateau support (203) du dispositif adaptateur (20), lequel comporte des moyens de positionnement (206) pour le centrage de la boîte, des moyens de retenue (205) pour son maintien stable sur le plateau support (203), des moyens d'étanchéité (219) pour assurer l'étanchéité de la boîte et de l'équipement par rapport à l'extérieur du système, et des moyens de lecture et de transmission (230) des informations relatives aux boîtes individuelles ou collectives.

5. Dispositif adaptateur selon la revendication 1, caractérisé en ce que le dispositif adaptateur (20) est placé sur un dispositif de rangement (30) fixé au dispositif d'interface (2).

6. Dispositif adaptateur selon la revendication 5, caractérisé en ce que le dispositif de rangement (30) est équipé d'un tiroir coulissant (301) déplaçable à partir d'une position de stockage vers une position de saillie pour autoriser le chargement automatique du dispositif adaptateur (20) sur le plateau (22) du dispositif d'interface (2).

7. Dispositif adaptateur selon la revendication 6, caractérisé en ce que le tiroir coulissant (301) est doté d'un mécanisme élévateur (306) pour soulever le dispositif adaptateur (20) à partir de la position de saillie jusqu'à une position relevée correspondant sensiblement au niveau du plateau (22) mobile du dispositif d'interface (2).

8. Dispositif adaptateur selon la revendication 4, caractérisé en ce que la paroi latérale (204) du dispositif adaptateur (20a, 20b) est rendue mobile pour autoriser un chargement par le haut de la boîte (10) et coopère avec un dispositif de guidage (209) associé à un ressort de rappel (210) pour assurer le verrouillage et le déverrouillage des moyens de retenue (205).

9. Dispositif adaptateur selon la revendication 8, caractérisé en ce que la face externe (212) de la paroi latérale (204) est recouverte par une plaquette (214) de protection contre les contaminations, laquelle est automatiquement enlevée de ladite face (212), et transférée sur la deuxième porte (21) au moment de la liaison mécanique des deux portes (101, 21), suite au recul du dispositif de guidage (209) dans le sens du verrouillage, après accostage de la paroi latérale (204) avec la face avant du dispositif d'interface (2), la contamination se trouvant ainsi piégée entre la plaquette (214) et la deuxième porte (21).

10. Dispositif adaptateur selon la revendication 8, caractérisé en ce que la face externe (212) de la paroi latérale (204) porte un bloc adhésif multifeuilles interchangeable, le retrait d'une feuille contaminée intervenant à chaque utilisation du dispositif adaptateur (20a) pour laisser apparaître une nouvelle feuille exempte de contamination particulaire.

11. Dispositif adaptateur selon la revendication 1, caractérisé en ce que le dispositif adaptateur (20) est associé à une desserte mobile (40) équipée de moyens de positionnement (402) par rapport au dispositif d'interface, et d'un mécanisme élévateur et abaisseur (401) autorisant la pose et la dépose du dispositif adaptateur (20) sur le plateau du dispositif d'interface.
